(19) Europäisches Patentamt
European Patent Office
Office européen des brevets

(11) **EP 2 888 599 B1**

(12) **FASCICULE DE BREVET EUROPEEN**

(45) Date de publication et mention de la délivrance du brevet:
**27.05.2020 Bulletin 2020/22**

(21) Numéro de dépôt: **13747680.0**

(22) Date de dépôt: **09.08.2013**

(51) Int Cl.:
*G01R 31/389* (2019.01)   *G01R 31/392* (2019.01)

(86) Numéro de dépôt international:
**PCT/EP2013/066761**

(87) Numéro de publication internationale:
**WO 2014/029647 (27.02.2014 Gazette 2014/09)**

(54) **PROCÉDÉ D'ESTIMATION DU VIEILLISSEMENT D'UNE BATTERIE**

VERFAHREN ZUR SCHÄTZUNG DER ALTERUNG EINER BATTERIE

METHOD FOR ESTIMATING THE AGEING OF A BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.08.2012 FR 1202266**

(43) Date de publication de la demande:
**01.07.2015 Bulletin 2015/27**

(73) Titulaires:
• **Airbus Defence and Space SAS**
  **78130 Les Mureaux (FR)**
• **Centre National d'Etudes Spatiales (CNES)**
  **75001 Paris (FR)**

(72) Inventeurs:
• **GAJEWSKI, Laurent**
  **31130 Quint Fonsegrives (FR)**
• **TABERNA, Pierre-Louis**
  **31750 Escalquens (FR)**
• **SIMON, Patrice**
  **31400 Toulouse (FR)**

(74) Mandataire: **Ipside**
  **6, Impasse Michel Labrousse**
  **31100 Toulouse (FR)**

(56) Documents cités:
**EP-A1- 1 298 444    EP-A1- 1 892 536**
**EP-A1- 2 375 487    WO-A1-99/66340**
**US-A- 4 678 998**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

La présente invention relève du domaine des dispositifs et procédés de test.

Elle concerne plus particulièrement un procédé de diagnostic du vieillissement d'une batterie.

**Préambule et art antérieur**

Le problème de la détermination du vieillissement d'une batterie trouve de nombreuses applications, notamment dans le cadre de batteries installées à bord de satellites. Dans un tel cas, la connaissance de l'état de la batterie est indispensable pour déterminer la fin de vie du satellite. En l'absence de connaissance précise de l'état du vieillissement de la batterie, le satellite est désactivé précocement, générant ainsi une perte opérationnelle significative.

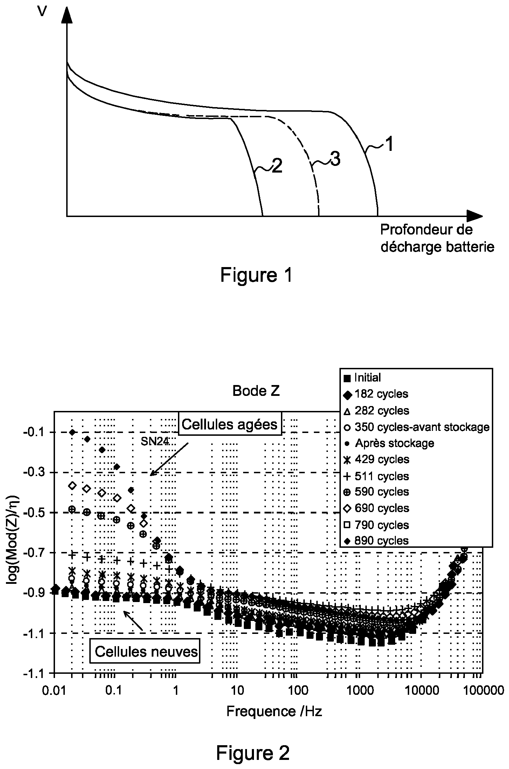

Le comportement d'une batterie en fonction de son vieillissement est illustré par la figure 1, qui montre en abscisses la profondeur de décharge de la batterie (écart entre la charge maximale et la charge minimale de la batterie), et en ordonnées le voltage aux bornes de la batterie. Comme on le voit sur la figure 1, pour une batterie en début de vie (courbe 1), la profondeur de décharge disponible est maximale, et la courbe de voltage fournie par la batterie est sensiblement plate jusqu'à une chute rapide du voltage, lorsque la profondeur de décharge maximale est presque atteinte. Pour une batterie en fin de vie (courbe 2), la situation est identique, avec un plateau légèrement plus bas en voltage de batterie en fonctionnement normal, et une chute rapide de voltage au voisinage de la profondeur de décharge.

La courbe 3 (en pointillés sur la figure 1), correspondant à une batterie d'âge quelconque, se trouve, sur ce graphique, entre les deux courbes précédentes. La simple mesure du voltage observé sur le plateau en début d'utilisation de la batterie (partie gauche de la courbe), ne suffit pas à caractériser précisément le vieillissement de la batterie. Il en résulte donc une grande incertitude sur le moment de la chute rapide de voltage de la batterie.

Les méthodes usuelles de détermination du vieillissement d'une batterie comprennent la mesure de sa résistance interne et de la perte de capacité de la batterie (baisse de la profondeur de décharge). La mesure de capacité est basée sur une décharge complète de la batterie à courant constant.

Ces paramètres de capacité et de résistance interne ne sont donc pas accessibles pour un équipement embarqué, par exemple à bord d'un satellite. Par ailleurs, une décharge complète de batterie à bord d'un satellite entrainerait la perte de celui-ci, et cette solution n'est donc pas envisageable.

On connait par ailleurs des méthodes de diagnostic de vieillissement de batterie, adaptées à des équipements embarqués.

La demande de brevet US 2012/0019253 A1 "Method for determining and aging condition of a battery cell by means of impedance spectroscopy" décrit une méthode de diagnostic basée sur la comparaison entre une impédance basse fréquence de la batterie réelle, et une impédance seuil, caractéristique d'une batterie en fin de vie.

La mesure d'impédance basse fréquence de la batterie est réalisée ici par mesure de la tension de la batterie, lorsque celle-ci est soumise à l'injection d'un courant comportant des variations sinusoïdales de fréquence variable (méthode par spectroscopie d'impédance).

La méthode est applicable à divers types de batteries : Li-Ion Li-Polymère, NiCd, NiMH, etc.

De même, la publication "Impedance Noise Identification for State-of-Health Prognostics" (INL/CON-08-14101, 43rd Power Sources Conference, july 2008) décrit une méthode de diagnostic de vieillissement utilisant une mesure d'impédance de la batterie, basée ici sur l'injection d'un courant aléatoire (bruit blanc et bruit rose) dans la batterie. La méthode utilise alors un traitement par FFT (transformée de Fourier rapide) pour déterminer l'impédance de la batterie. Ici encore, cette impédance mesurée est comparée à des valeurs de référence.

On connait dans ce domaine un document EP 1 892 536 A1 relatif à l'analyse de vieillissement de batterie de type au plomb, telle qu'utilisée particulièrement dans un véhicule automobile. Ce document décrit un système de calcul de spectre d'impédance utilisant une mesure réalisée lors des impulsions de démarrage (impulsion à haute fréquence fiable et demandée comme étant reproductible), et complétée si nécessaire par des impulsions de test utilisant une charge contrôlable dédiée à cet effet. Ce document cite les limites d'un modèle utilisant simplement une impulsion de démarrage comme source de données, et introduit une charge contrôlable destinée aux mesures avec une impulsion de test. Ces charges de test peuvent faire partie des équipements électriques normaux du véhicule, mais ils sont pilotés pour générer des impulsions au moment de la mesure de vieillissement. La mesure a donc lieu soit au moment de l'impulsion de démarrage, soit lors d'impulsions de test.

On connait également un document brevet US 4.678.998, également relatif à la mesure précise de vieillissement d'une batterie acide-plomb de véhicule automobile. Ce document cite que les différentes charges reliées à la batterie vont produire des composantes en fréquence différentes en tension et courant sur la batterie. Ce document décrit un dispositif dans lequel la tension et le voltage aux bornes d'une batterie automobile sont mesurés en permanence, des mesures d'impédance sont calculées aux différentes fréquences associées aux charges reliées à la batterie. Finalement, le système compare ses résultats de mesure à des courbes préenregistrées pour chacune des fréquences associées au fonctionnement des charges.

On connait encore un document EP 2 375 487 qui concerne une méthode d'identification de modèle représentatif du vieillissement d'une batterie, en utilisant une séquence (M-sequence) injectée dans la batterie. Ceci ressort clairement du texte, notamment §10. D3 décrit une étape de sélection d'un modèle d'évolution de l'impédance, et en exemple cite un modèle ARX.

**Exposé de l'invention**

L'invention vise, en premier lieu, un procédé d'estimation du vieillissement d'une batterie alimentant un système électrique selon la revendication 1, comportant:

100 - une étape d'enregistrement d'un ensemble de données de tension et courant aux bornes de la batterie, en réponse aux perturbations en courant provoquées durant le fonctionnement normal de la batterie par les changements de régime de consommation du système électrique,
200 - une étape de détermination de l'impédance de la batterie, dans une plage de fréquences prédéterminée, à partir des données de tension et courant,
300 - une étape d'estimation de l'âge de la batterie en fonction de l'impédance déterminée à l'étape précédente, par comparaison de ladite impédance avec un modèle préalablement enregistré d'évolution de cette impédance selon le vieillissement.

Le vieillissement d'une batterie se traduit principalement par une perte de capacité et une augmentation de sa résistance interne.

Les perturbations de courant sont induites ici par les changements de régime de consommation du système, dont fait partie la batterie à tester, lors du fonctionnement opérationnel du système. Usuellement, dans l'art antérieur, les impédances sont déterminées par injection de perturbations de type sinus à différentes fréquences (vobulation) sur le courant et la mesure de la tension résultante.

Dans l'invention, il n'est plus nécessaire d'injecter de courant de forme prédéterminée aux bornes de la batterie pour en tester le vieillissement. Cette disposition permet de s'affranchir de l'emport d'un équipement de génération de courant destiné à ce test.

La mesure d'impédance est faite uniquement grâce au système d'acquisition des télémesures du courant et de la tension batterie. Le diagnostic de la batterie peut donc être réalisé tout au long de la vie de la batterie, sans modification du système, sans injection de perturbations, et peut être effectué lorsque le système embarquant la batterie est en fonctionnement normal.

Du fait de l'utilisation de télémesures de données de courant et tension mesurées aux bornes de la batterie lors du fonctionnement normal de la batterie, il est possible, pour les équipements pour lesquels ces données sont enregistrées en permanence, de déterminer tout au long de la vie de la batterie l'état de vieillissement de la batterie. Il est également possible après coup de déterminer son profil de vieillissement lors de son fonctionnement normal.

L'impédance est ici déterminée par son module et/ou sa phase.

Dans certains systèmes, l'alimentation électrique peut se faire simultanément par la batterie et une autre source de puissance. Par exemple, sur un satellite, cette autre source de puissance est le générateur solaire. Cela permet d'augmenter la puissance disponible quand la puissance du générateur solaire est insuffisante. Il est préférable de faire les mesures quand le générateur solaire ne fournit pas de courant, ce qui est le cas pendant les éclipses. Dans ce mode de mise en œuvre, l'étape 100 est réalisée quand le système électrique est alimenté seulement par la batterie

Lorsque la batterie est de type Li-Ion, la plage de fréquences prédéterminée est comprise dans la bande 0.01 - 3 Hz. Cette plage de fréquence a été déterminée par la demanderesse comme mettant en évidence des écarts maximums de module ou de phase d'impédance complexe de la batterie, pour une batterie de type Li-Ion, lors du vieillissement de la batterie. Une observation du spectre d'impédance dans cette plage permet donc au mieux de déterminer l'âge de la batterie.

Pour réaliser la détermination de l'impédance basse fréquence de la batterie à partir des données de tension et courant, le procédé d'estimation du vieillissement d'une batterie comporte avantageusement :

210 - une sous-étape d'identification des paramètres d'une structure de modèle prédéterminée à partir des données mesurées de tension et de courant,
220 - une sous-étape de conversion du modèle identifié en domaine fréquentiel,
230 - enfin une sous-étape de calcul de l'impédance basse fréquence de la batterie.

Dans un mode particulier de réalisation, la structure de modèle est choisie parmi les modèles suivants : ARMAX, ARX, Box Jenkins, Output Error.

Ces modèles connus permettent une mise en œuvre simple du procédé de l'invention.

Dans une mise en œuvre particulière du procédé, celui-ci comporte une étape de correction de l'impédance calculée, pour tenir compte de la température de l'environnement de la batterie.

L'invention vise en second lieu un dispositif d'estimation de vieillissement de batterie, adapté à mettre en œuvre un procédé tel qu'exposé.

Sous un autre aspect, l'invention vise un satellite, comprenant un dispositif tel qu'exposé ci-dessus.

Sous encore un autre aspect, l'invention vise un produit programme d'ordinateur mettant en œuvre un procédé tel qu'exposé.

**Présentation des figures**

Les caractéristiques et avantages de l'invention seront mieux appréciés grâce à la description qui suit, description qui expose les caractéristiques de l'invention au travers d'un exemple non limitatif d'application.

La description s'appuie sur les figures annexées qui représentent :

Figure 1 : (déjà citée) : une famille de courbes illustrant, pour divers âges de batterie, la baisse de voltage d'une batterie selon la profondeur de décharge atteinte,

Figure 2 : une famille de courbes illustrant, pour divers nombre de cycles d'utilisation d'une batterie, la variation du module de l'impédance en fonction de la fréquence,

Figure 3 : une famille de courbes illustrant, pour divers nombre de cycles d'utilisation d'une batterie, la variation de la phase de l'impédance en fonction de la fréquence.

Figure 4 : un organigramme des étapes d'un exemple de mise en œuvre du procédé d'estimation de vieillissement de batterie,

Figure 5 : un organigramme de détail de l'étape de test de référence de vieillissement d'une batterie,

Figure 6 : un organigramme plus détaillé des étapes d'identification et de validation d'un modèle d'impédance,

Figure 7 : une famille de courbes illustrant la comparaison entre les abaques d'impédance basse fréquence mesurée au sol sur une batterie test, et l'impédance BF de la structure de modèle identifiée pour cette batterie,

Figure 8 : un organigramme d'un procédé de post-traitement des données de mesures brutes de courant et tension aux bornes de la batterie en conditions d'utilisations réelles,

Figure 9 : un organigramme des étapes d'estimation de l'âge de la batterie réelle étudiée.

**Description détaillée d'un mode de réalisation de l'invention**

On considère ici une batterie de type Lithium-Ion, soumise à une série de cycles de charge / décharge. C'est par exemple le cas d'une batterie embarquée à bord d'un satellite, et qui doit fournir de la puissance électrique à chaque passage du satellite dans l'ombre de la Terre.

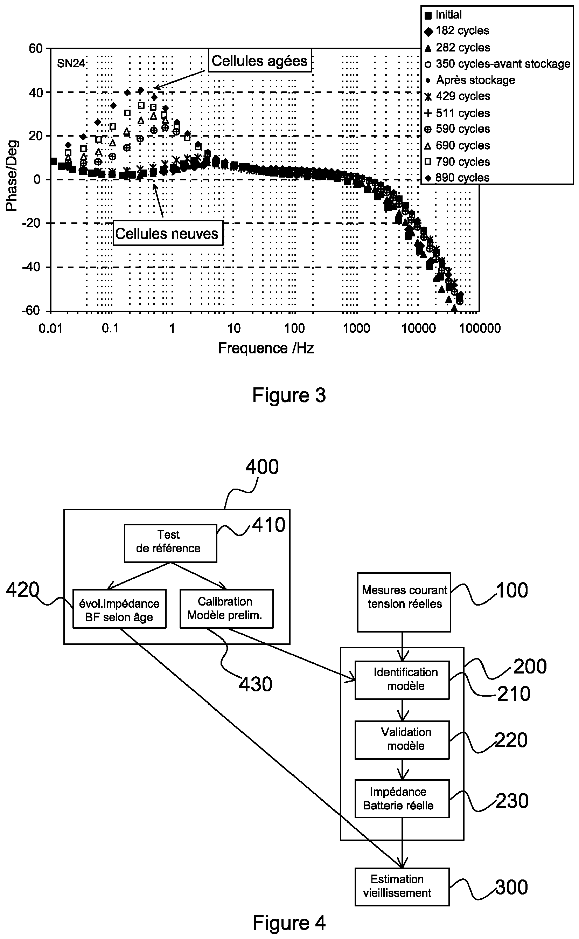

Il a été déterminé par la demanderesse des courbes de variation d'impédance d'une batterie à basse fréquence (typiquement entre 0.01 Hz et 10 Hz) avec le nombre de cycles d'utilisation de ladite batterie (voir figures 2 et 3). La figure 2 illustre la variation du module de l'impédance en fonction de la fréquence, et l'évolution de cette courbe selon le nombre de cycles de fonctionnement de la batterie. De même, la figure 3 illustre la variation de la phase de l'impédance en fonction de la fréquence, et l'évolution de cette courbe selon le nombre de cycles de fonctionnement de la batterie.

On constate sur ces deux familles de courbes des écarts significatifs entre les valeurs mesurées pour une batterie "âgée" (par exemple au-delà de 600 cycles d'utilisation) et une batterie neuve. De façon générale, le module et la phase de l'impédance augmentent avec le vieillissement de la batterie.

Ces familles de courbes permettent la réalisation d'abaques exprimant la valeur du module d'impédance ou de la phase d'impédance en fonction du nombre de cycles, à une fréquence donnée, par exemple 0.3 à 1 Hz (valeurs donnant un écart maximum de phase entre des cellules âgées ou neuves) ou 0.02 Hz (valeur donnant, dans le présent exemple, un écart maximum de module d'impédance entre des cellules âgées ou neuves).

A partir de telles abaques, une mesure d'impédance basse fréquence d'une batterie Lithium-Ion utilisée en conditions réelles, ladite batterie réelle étant d'un type similaire à la batterie utilisée pour la génération des abaques, permet de déterminer son niveau de vieillissement.

La figure 4 illustre alors plus précisément les étapes du procédé, dans un exemple de mise en oeuvre, appliqué ici à l'estimation du vieillissement d'une batterie embarquée à bord d'un satellite. Le procédé s'applique néanmoins à tout type de batterie, par exemple batterie de téléphone ou d'ordinateur portable.

Comme on le voit sur cette figure 4, le procédé comporte les étapes suivantes :

100 - une étape d'enregistrement d'un ensemble de données de tension et courant aux bornes de la batterie, en réponse aux perturbations en courant provoquées durant le fonctionnement normal de la batterie par les changements de régime de consommation du système électronique,

200 - une étape de détermination de l'impédance de la batterie, dans une plage de fréquences prédéterminée, à partir des données de tension et courant,

300 - une étape d'estimation de l'âge de la batterie en fonction de l'impédance basse fréquence mesurée, par comparaison de ladite impédance avec un modèle préalablement enregistré par exemple sous forme d'abaques d'évolution de cette impédance selon le vieillissement.

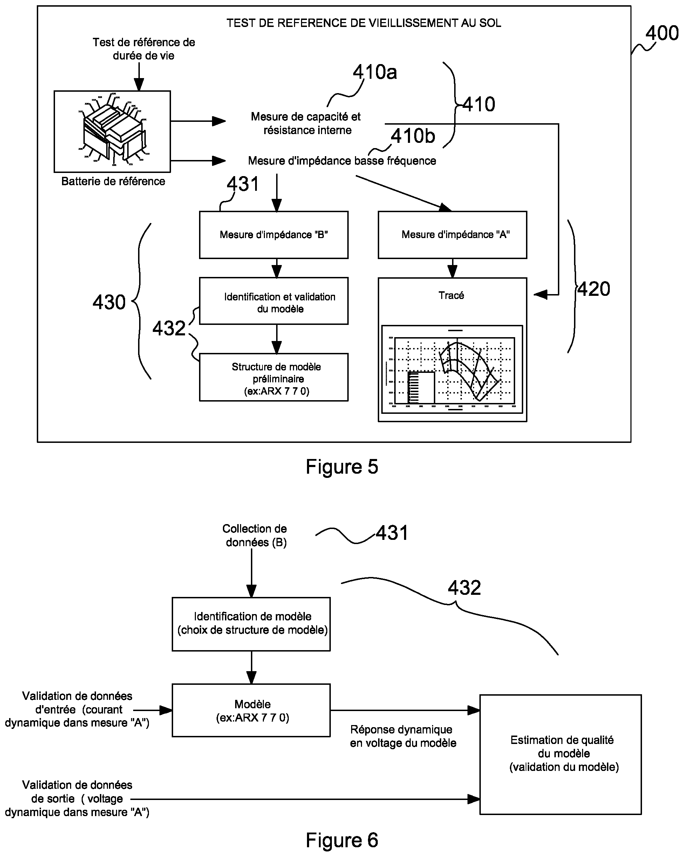

Dans un exemple nullement limitatif de mise en œuvre du procédé, ce modèle d'évolution est obtenu, dans une étape 400 de test de vieillissement référence, menée préliminairement aux autres étapes. La figure 5 représente un organigramme de l'étape 400 de test de référence de vieillissement.

Un "test de vieillissement de référence" consiste à ajouter une étape de mesure d'impédance 410b à un test de vieillissement de batterie existant (mesure de variation de résistance et de capacité, étape 410a).

Une série de mesures (A, étape 410b) de l'impédance basse fréquence réalisée sur la base de l'injection aux bornes de la batterie de perturbations sinusoïdales en courant permet de déterminer l'évolution d'impédance BF en fonction du vieillissement.

Dans une étape d'identification d'un modèle préliminaire de la batterie de test (étape 430), une seconde série de mesures (B, étape 431) permet de reproduire les données de télémesures brutes en conditions d'utilisation réelles de la batterie. Ceci permet, dans une étape 432, de calibrer un modèle de structure préliminaire qui convertit les données de télémesures brutes de la batterie en impédance BF.

Le modèle préliminaire identifié, pour le type de batterie soumis à test de vieillissement de référence, peut ensuite être appliqué aux télémesures réelles de la batterie en cours d'utilisation, afin d'évaluer son impédance basse fréquence dans ses conditions d'utilisation normales.

Plus précisément, pendant des tests de durée de vie d'une batterie (cyclage de la batterie), la capacité et la résistance interne de la batterie (ou d'un des éléments de la batterie si celle-ci est constituée d'un ensemble d'éléments identiques) sont mesurées régulièrement.

Une mesure d'impédance régulière dans les basses fréquences (0.05Hz - 1Hz) est réalisée durant ce test de durée de vie.

La mesure de l'impédance à basse fréquence est préférentiellement réalisée pendant la décharge pour éviter des perturbations dues au régulateur de charge de batterie, lorsque celui-ci existe.

Comme on l'a dit, les mesures d'impédance basse fréquence se composent de deux mesures distinctes :

Etape 410b : obtention des mesures A (perturbations sinusoïdales)
Sur la base de nombreuses perturbations sinusoïdales, le module et la phase de l'impédance basse fréquence de la batterie sont déterminées entre 0,05 Hz et 1 Hz. L'acquisition du courant et de la tension de la batterie doit préférentiellement se produire dans la phase de décharge (par exemple: 10 minutes après le début de la décharge).
Etape 431: obtention des mesures B (simulation d'un courant représentatif de conditions réelles d'utilisation).

Un courant de batterie typique de conditions d'utilisation réelles est injecté dans la batterie utilisée pour le «test de référence de vieillissement » pour simuler un profil réel d'utilisation de batterie. L'enregistrement du courant et de la tension de la batterie doit se produire dans la phase de décharge (par exemple: dix minutes après le début de la décharge). Quelques minutes d'acquisition sont nécessaires (par exemple: dix minutes d'acquisition). Etant donné que l'impédance de la batterie doit préférentiellement être connue à partir de 0,05 Hz à 1Hz (pour le cas d'une batterie de type Lithium-Ion), la tension et le courant de la batterie peuvent être échantillonnés à une fréquence optimale de 10Hz. Sur la base de l'identification d'un modèle existant, les télémesures de courant et tension sont post-traitées et l'impédance basse fréquence de la batterie de test est déduite.

Au cours du test de référence 400, les mesures A permettent d'obtenir, dans une étape 420, une cartographie de l'évolution d'impédance basse fréquence en fonction du vieillissement (par exemple un ensemble de courbes de Nyquist en fonction du vieillissement). Les mesures de la capacité et de la résistance interne permettent l'étalonnage de chaque mesure A en termes de vieillissement.

La série de mesures B (simulation d'un courant représentatif de conditions réelles d'utilisation) permet d'identifier dans l'étape 430 une structure de modèle préliminaire (compromis entre plusieurs structures des modèles). Comme illustré figure 6, qui représente un organigramme de détail de l'étape 430, les données de mesure B mesure sont utilisées dans le processus d'identification de modèle, les données de la mesure A sont utilisées pour valider et estimer la qualité du modèle.

Le but des structures de modèle utilisées est de modéliser un système en temps discret comme une combinaison linéaire des données passées d'entrée, de sortie et de perturbations. On considère ici à titre d'exemple nullement limitatif une structure de modèle pour la modélisation d'une batterie. D'autres structures de modèles pourraient également être utilisées, sans modifier la mise en œuvre du procédé.

**Structure de modèle ARX** (Auto Régressive model with eXternal inputs)

Dans le cas de la modélisation d'une batterie, *u* (entrée) représente le courant dynamique de la batterie, *y* (sortie) est le voltage dynamique de la batterie, et *e* (bruit blanc) représente les perturbations de mesure

Il est à noter que le voltage dynamique (respectivement le courant dynamique) correspond au voltage (respectivement au courant) de la batterie sans la partie de courant continu.

Ce modèle s'écrit alors :

$$A(q)y(t) = B(q)u(t) + e(t) \quad \text{(équation 1)}$$

Avec :

$$A(q) = 1 + a_1 q^{-1} + \ldots\ldots + a_{Na} q^{-Na}$$

$$B(q) = b_1 q^{-Nk} + \ldots\ldots + b_{Nb} q^{-Nk-Nb+1}$$

$$(1 + a_1 q^{-1} + \ldots\ldots + a_{Na} q^{-Na})y(t) = (b_1 q^{-Nk} + \ldots\ldots + b_{Nb} q^{-Nk-Nb+1})u(t) + e(t)$$

D'où :

$$y(t) = -a_1 y(t-1) - \ldots\ldots - a_{Na} y(t-Na) + b_1 u(t-Nk) + \ldots\ldots$$
$$+ b_{Nb} u(t-Nk-Nb-1) + e(t)$$

Pour une structure de modèle ARX (*Na; Nb; Nk*), les coefficients à identifier sont : $a_1, \ldots a_{Na}, b_1, \ldots, b_{Nb}$ *Nk* représentant le retard.

Les étapes d'identification d'un modèle sont connues en soi et ne sont donc pas détaillées plus avant ici.

La structure du modèle le plus adéquat, c'est-à-dire celle qui présente la meilleure corrélation pour toutes les mesures dans le test de vie (par exemple, stabilité de la structure du modèle avec le vieillissement de la batterie) peut ensuite être utilisée pour le post-traitement des télémesures brutes en conditions d'utilisation réelles (étape 200 de traitement au sol selon télémesures réelles).

La validation du modèle préliminaire est réalisée sur la base des mesures acquises dans l'étape 410 (mesure "A").

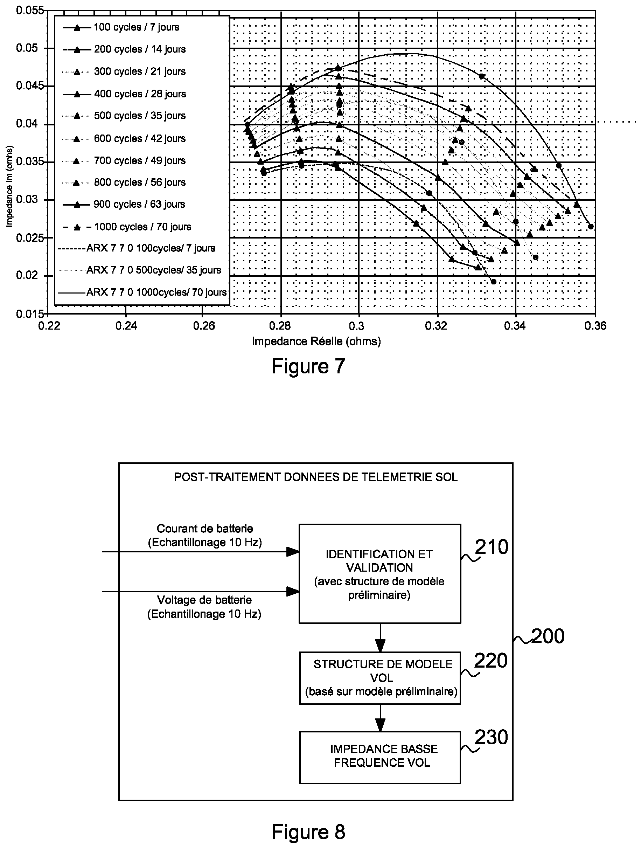

La figure 7 montre la comparaison entre une carte d'impédance basse fréquence et l'impédance BF de la structure de modèle préliminaire identifié.

On note que chaque ligne pointillée représente l'impédance basse fréquence de la batterie, déterminée grâce à l'injection de perturbations sinusoïdales dans une fréquence comprise entre 0.05Hz et 1Hz (mesure A).

Les lignes continues représentent l'impédance basse fréquence de la batterie, telle que déterminée à partir des données brutes de courant et de voltage (mesure B).

A partir des mesures B, le comportement à basse fréquence de la batterie test est modélisé avec une grande précision. En termes de vieillissement, une résolution comprise entre 2 et 3 semaines est possible comme le montre la figure 8 (correspondant approximativement à 0,5% de la perte de capacité).

**Etape 100** : **acquisition des données de courant et tension en conditions réelles d'utilisation**

Ces mesures sont acquises à tout moment lors de l'utilisation normale de la batterie. Elles couvrent préférentiellement au moins une période de décharge de la batterie.

Les télémesures de la batterie (courant et tension de la batterie) doivent être échantillonnées à un taux minimum de 10Hz.

La température de la batterie est préférentiellement également mesurée, de manière à pouvoir tenir compte d'une dérive de l'impédance selon la température de fonctionnement de la batterie.

Le taux d'échantillonnage de la température peut être beaucoup plus lent que 10Hz (1/16Hz est largement suffisant).

L'acquisition des télémesures doit préférentiellement couvrir la phase de décharge (par exemple: 10 minutes après le début de la décharge).

Pour réaliser l'identification du modèle de batterie (étape 200), il est nécessaire de créer un ensemble de données constitué par des données d'identification et des données de validation. Les données pour l'identification et les données pour la vérification doivent être différentes (par exemple courant et tension, de façon similaire à la figure 6).

La collecte de données réelles est avantageusement choisie de manière à minimiser l'erreur de variance (pour une longue séquence de mesure) et l'erreur de biais (plusieurs points de fonctionnement). Ainsi, chaque groupe peut comprendre plusieurs acquisitions. La durée de chaque acquisition doit être suffisante (par exemple plusieurs minutes). L'intervalle d'échantillonnage doit être suffisant pour observer la réponse dynamique entre 0.05Hz et 1Hz. L'échantillonnage optimal a été déterminé à 10Hz

La collecte de données peut être réalisée sur une courte période (par exemple: en orbite terrestre basse, il peut être composé de 1 acquisition (de quelques minutes) sur chaque orbite au cours de 1 jour pour éviter d'avoir de grandes variations de vieillissement de la batterie au cours de cet horizon de temps. (En effet, il n'y a pas dans ce cas de vieillissement observable sur un jour).

**Etape 200** : **détermination de l'impédance basse fréquence de la batterie à partir des données temporelles de tension et courant.**

Dans l'étape 200, pour déterminer l'impédance basse fréquence de la batterie réelle, une structure de modèle est identifiée grâce aux télémesures brutes (courant et tension) dans le domaine temporel.

Dans une première sous-étape (210) on identifie une structure de modèle la plus proche des données mesurées, selon une fonction de distance prédéterminée, ou en se basant sur la structure de modèle préliminaire identifiée dans l'étape 430. Les coefficients spécifiques à appliquer dans la structure du modèle préliminaire (déterminé dans l'étape 430) sont identifiés grâce à l'ensemble de données.

Dans une seconde sous-étape (220), on convertit le modèle identifié en domaine fréquentiel. Enfin, dans une troisième sous-étape (230), on calcule l'impédance basse fréquence de la batterie utilisée en conditions réelles d'utilisation.

La Figure 8 présente le procédé de post-traitement au sol des données de télémesures

**Etape 300** : **évaluation de vieillissement de batterie**

Cette estimation est réalisée en fonction de l'impédance basse fréquence calculée, par comparaison de ladite impédance avec un modèle préalablement enregistré (par exemple sous forme d'abaques) d'évolution de cette impédance selon le vieillissement.

Un modèle d'évolution de l'impédance basse fréquence d'une batterie du type de la batterie réelle à étudier, en fonction de son vieillissement peut être obtenu par toute méthode.

Dans le présent exemple, l'impédance basse fréquences de la batterie en conditions réelles (évaluée dans le post-traitement au sol des données de télémesure) est comparée avec la cartographie de l'évolution d'impédance basse fréquence en fonction du vieillissement (obtenue à partir du test de vieillissement de référence).

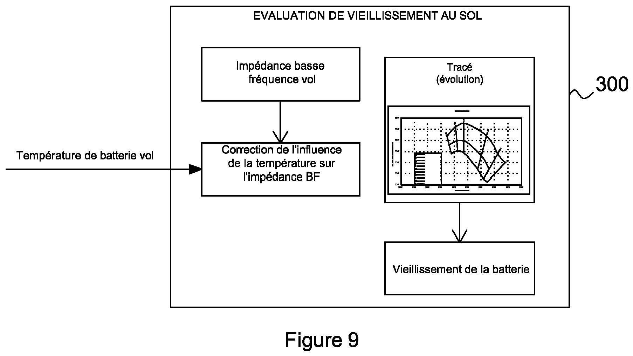

Grâce à la comparaison des impédances basse fréquence, le vieillissement (perte de capacité / augmentation de la résistance interne) est déduit (figure 9).

Si la configuration de la batterie en vol (nombre d'accumulateurs en séries et en parallèles constituants la batterie) est différente de celle utilisée dans le test de référence, l'impédance de la batterie en vol et les abaques d'évolution de l'impédance en fonction du vieillissement seront déduites pour une configuration normalisée (par exemple pour un accumulateur, pour la configuration de la batterie sous test ou pour la configuration de la batterie en vol,...), afin de pouvoir directement être comparées.

Si la température en vol n'est pas le même que celle dans le test de référence, l'estimation de l'impédance basses fréquences en conditions réelles sera corrigée afin de tenir compte de l'effet de la température sur l'impédance basse fréquence. Elle implique d'avoir déterminé au préalable, par toute méthode, les lois d'évolution d'impédance basse fréquence en fonction de la température.

Dans un cas particulier de mise en œuvre du procédé, cette correction est réalisée par :

1/ détermination des lois d'évolution d'impédance basse fréquence en température lors du test de référence (Le test de référence est réalisé à une température donnée. A un vieillissement donné, l'impédance basse fréquence de la batterie est mesurée pour différentes températures de la gamme d'utilisation de la batterie en vol. L'évolution de l'impédance basse fréquence en fonction de la température est mesurée pour plusieurs niveaux de vieillissement au cours du test de référence. Ainsi les lois d'évolution de l'impédance BF en fonction de la température sont établies).

2/ correction de l'impédance estimée en vol à partir des lois d'évolution en température pour déterminer l'impédance normalisée de la batterie en vol à la température du test de référence (comme indiqué sur la figure 10).

**Avantages**

Dans l'art antérieur, la mesure décrite dans le cadre de la demande de brevet "Method for determining and aging condition of a battery cell by means of impedance spectroscopy" (citée plus haut) est intrusive puisqu'elle nécessite un équipement dédié permettant de générer un courant d'excitation en sinus de fréquences variables. De ce fait, la mesure de l'impédance basse fréquence est impossible lorsque le système embarquant la batterie (satellite, voiture, ...) fonctionne, car dans ce cas le courant de la batterie est perturbé par les différents régimes de consommation. Une telle mesure serait seulement possible en arrêtant le système, ce qui est impossible dans le cas d'un satellite.

Au contraire, le procédé décrit ici, basé sur une méthode non intrusive de détermination de l'impédance basse fréquence, permet de réaliser une mesure « en direct », lorsque le système embarquant la batterie est en fonctionnement normal. Aucune perturbation n'est injectée dans la batterie.

Le procédé décrit permet la précision d'une méthode par spectroscopie d'impédance, sans nécessiter d'équipement d'injection de signal aux bornes de la batterie, et sans gêner en quoi que ce soit le déroulement du système dont fait partie la batterie.

**Revendications**

1.    Procédé d'estimation du vieillissement d'une batterie de type Li-Ion alimentant un système électrique, comportant:

100 - une étape d'enregistrement d'un ensemble de données de tension et courant aux bornes de la batterie, en réponse aux perturbations en courant provoquées durant le fonctionnement normal de la batterie par les changements de régime de consommation du système électrique,

200 - une étape de détermination de l'impédance de la batterie, dans une plage de fréquences prédéterminée, à partir des données de tension et courant, cette étape comportant :

210 - une sous-étape d'identification des paramètres d'une structure de modèle prédéterminée à partir des données mesurées de tension et de courant, ladite structure de modèle permettant de modéliser une batterie en temps discret comme une combinaison linéaire des données passées d'entrée, de sortie et de perturbations,

220 - une sous-étape de conversion du modèle identifié en domaine fréquentiel,

230 - enfin une sous-étape de calcul de l'impédance basse fréquence de la batterie.

300 - une étape d'estimation de l'âge de la batterie en fonction de l'impédance déterminée à l'étape précédente, par comparaison de ladite impédance avec un modèle préalablement enregistré d'évolution de cette impédance selon le vieillissement,

la plage de fréquences prédéterminée étant comprise dans la bande 0.01 - 3 Hz.

2.    Procédé selon la revendication 1, **caractérisé en ce que** l'étape 100 est réalisée quand le système électrique est alimenté seulement par la batterie.

3.    Procédé selon l'une quelconque des revendications 1 à 2, **caractérisé en ce que** la structure de modèle est choisie parmi les modèles suivants : ARMAX, ARX, Box Jenkins, Output error.

4.    Procédé selon l'une quelconque des revendications 1 à 3, **caractérisé en ce qu'**il comporte une étape de correction de l'impédance calculée, pour tenir compte de la température de l'environnement de la batterie.

5.    Procédé selon l'une quelconque des revendications 1 à 4, **caractérisé en ce qu'**il comporte une étape 400 de test de vieillissement référence, menée préliminairement aux autres étapes, permettant de déterminer un modèle d'évolution d'impédance de la batterie selon le vieillissement.

6.    Procédé selon la revendication 5, **caractérisé en ce qu'**il comporte :

- une étape 410b de mesure de module et phase de l'impédance A à basse fréquence (0.05Hz - 1 Hz) réalisée sur la base de l'injection aux bornes de la batterie de perturbations sinusoïdales en courant permettant de déterminer l'évolution d'impédance BF en fonction du vieillissement, cette étape étant réalisée durant des tests de durée de vie de la batterie (cyclage de la batterie),
- une étape d'identification d'un modèle préliminaire de la batterie de test (étape 430),
- une seconde série de mesures (B, étape 431) du courant et de la tension aux bornes de la batterie, permettant de reproduire les données de télémesures brutes en conditions d'utilisation réelles de la batterie,
- une étape 432, de calibration d'un modèle de structure préliminaire qui convertit les données de télémesures brutes de la batterie en impédance BF.

7. Procédé selon l'une quelconque des revendications 1 à 6, **caractérisé en ce que** les mesures d'impédance à basse fréquence sont réalisées pendant une phase de décharge de la batterie.

8. Procédé selon l'une quelconque des revendications 1 à 7, **caractérisé en ce que** la tension et le courant de la batterie sont échantillonnés à une fréquence voisine de 10Hz.

9. Procédé selon l'une quelconque des revendications 1 à 8, **caractérisé en ce que**, dans l'étape 100, les mesures sont acquises à tout moment lors de l'utilisation normale de la batterie, ces mesures couvrant au moins une période de décharge de la batterie.

10. Dispositif de diagnostic de vieillissement de batterie, **caractérisé en ce qu'**il met en œuvre un procédé selon l'une quelconque des revendications 1 à 9.

11. Satellite, **caractérisé en ce qu'**il comprend un dispositif selon la revendication 10.

12. Produit programme d'ordinateur comprenant des instructions qui, lorsque le programme est exécuté par un ordinateur, conduisent celui-ci à mettre en œuvre un procédé selon l'une quelconque des revendications 1 à 9.

**Patentansprüche**

1. Verfahren zur Schätzung der Alterung einer ein elektrisches System versorgenden Batterie vom Typ Li-Ion, Folgendes umfassend:

100 - einen Schritt der Registrierung einer Gesamtheit von Spannungs- und Stromdaten an den Polen der Batterie, als Reaktion auf die während dem normalen Betrieb der Batterie durch die Änderungen der Verbrauchsweise des elektrischen Systems verursachten Stromstörungen,
200 - einen Schritt der Bestimmung der Impedanz der Batterie in einem vorher festgelegten Frequenzbereich basierend auf Spannungs- und Stromdaten, wobei dieser Schritt folgendes umfasst:

210 - einen Unterschritt der Identifikation der Parameter einer vorher festgelegten Modellstruktur basierend auf gemessenen Spannungs- und Stromdaten, wobei es die Modellstruktur ermöglicht, eine Batterie in diskreter Zeit als eine lineare Kombination der vergangenen Eingangs-, Ausgangs- und Störungsdaten zu modellieren,
220 - einen Unterschritt der Konversion des Modells, identifiziert in der Frequenzdomäne,
230 - schließlich einen Unterschritt der Berechnung der Niederfrequenz-Impedanz der Batterie.

300 - einen Schritt der Schätzung des Alters der Batterie gemäß der im vorhergehenden Schritt bestimmten Impedanz durch Vergleich der Impedanz mit einem vorher registrierten Evolutionsmodell dieser Impedanz gemäß der Alterung,

wobei der vorher festgelegte Frequenzbereich in der Bandbreite 0,01 - 3 Hz liegt.

2. Verfahren nach Anspruch 1, **dadurch gekennzeichnet, dass** der Schritt 100 ausgeführt wird, wenn das elektrische System nur über die Batterie versorgt wird.

3. Verfahren nach einem der Ansprüche 1 bis 2, **dadurch gekennzeichnet, dass** die Modellstruktur ausgewählt ist aus den folgenden Modellen: ARMAX, ARX, Box Jenkins, Output error.

4. Verfahren nach einem der Ansprüche 1 bis 3, **dadurch gekennzeichnet, dass** es einen Schritt der Korrektur der berechneten Impedanz umfasst, um die Temperatur der Umgebung der Batterie zu berücksichtigen.

5. Verfahren nach einem der Ansprüche 1 bis 4, **dadurch gekennzeichnet, dass** es einen Schritt 400 des Tests der Referenzalterung enthält, im Vorfeld der anderen Schritte durchgeführt, die Bestimmung eines Evolutionsmodells der Impedanz der Batterie gemäß der Alterung ermöglichend.

6. Verfahren nach Anspruch 5, **dadurch gekennzeichnet, dass** es Folgendes umfasst:

   - einen Schritt 410b der Messung des Moduls und der Impedanzphase A bei niedriger Frequenz (0,05 Hz - 1 Hz), ausgeführt auf der Basis der Injektion an den Polen der Batterie von Sinusstörungen des Stroms, das Bestimmen der Entwicklung der Impedanz BF gemäß der Alterung ermöglichend, wobei dieser Schritt während Tests der Lebensdauer der Batterie ausgeführt wird (Zyklus der Batterie),
   - einen Schritt der Identifikation eines vorläufigen Modells der Testbatterie (Schritt 430),
   - eine zweite Reihe an Strom- und Spannungsmessung (B, Schritt 431) an den Polen der Batterie, das Reproduzieren der ferngemessenen Rohdaten bei realen Verwendungsbedingungen der Batterie ermöglichend,
   - einen Schritt 432 der Kalibrierung eines vorläufigen Strukturmodells, das die ferngemessenen Rohdaten der Batterie in Impedanz BF konvertiert.

7. Verfahren nach einem der Ansprüche 1 bis 6, **dadurch gekennzeichnet, dass** die Impedanzmessungen bei niedriger Frequenz während einer Entladungsphase der Batterie ausgeführt werden.

8. Verfahren nach einem der Ansprüche 1 bis 7, **dadurch gekennzeichnet, dass** die Spannung und der Strom der Batterie mit einer Nachbarfrequenz von 10 Hz stichprobenartig ausgewählt werden.

9. Verfahren nach einem der Ansprüche 1 bis 8, **dadurch gekennzeichnet, dass** in Schritt 100 die Messungen immer bei der normalen Verwendung der Batterie gewonnen werden, wobei diese Messungen wenigstens eine Entladungsperiode der Batterie abdecken.

10. Vorrichtung zur Diagnose der Batteriealterung, **dadurch gekennzeichnet, dass** es ein Verfahren nach einem der Ansprüche 1 bis 9 ausführt.

11. Satellit, **dadurch gekennzeichnet, dass** er eine Vorrichtung nach Anspruch 10 umfasst.

12. Computerprogramm-Produkt, Anweisungen umfassend, die, während das Programm durch einen Computer ausgeführt wird, diesen dazu veranlassen, ein Verfahren nach einem der Ansprüche 1 bis 9 auszuführen.

**Claims**

1. Method for estimating the ageing of a battery of Li-Ion type powering an electrical system, comprising:

   100 - a step of storing a set of data about the voltage and current across the battery terminals, in response to the current perturbations provoked during the normal operation of the battery by the changes of consumption rate of the electrical system,
   200 - a step of determining the impedance of the battery, within a predetermined frequency interval, from the voltage and current data, this step including

      210 - a sub-step of identifying the parameters of a predetermined model structure from measured voltage and current data, said model structure making it possible to model a time-discrete battery as a linear combination of past input, output and perturbation data,
      220 - a sub-step of converting the identified model into the frequency domain,
      230 - finally a sub-step of computing the low-frequency impedance of the battery:

   300 - a step of estimating the age of the battery as a function of the impedance determined in the preceding step, by comparing said impedance with a previously stored model of evolution of this impedance with ageing,

   the predetermined frequency interval being in the 0.01 - 3 Hz band.

2. Method according to claim 1, **characterized in that** the step 100 is performed when the electrical system is powered by the battery only.

3. Method according to any one of claims 1 to 2, **characterized in that** the model structure is chosen from among the following models: ARMAX, ARX, Box Jenkins, Output error.

4. Method according to any one of claims 1 to 3, **characterized in that** it includes a step of correcting the computed impedance, to take account of the temperature of the environment of the battery.

5. Method according to any one of claims 1 to 4, **characterized in that** it includes a reference ageing test step 400, conducted prior to the other steps, making it possible to determine a model of evolution of the impedance of the battery with ageing.

6. Method according to claim 5, **characterized in that** it includes:

   - a step 410b of measuring the magnitude and phase of the low-frequency impedance A (0.05 Hz - 1 Hz) performed on the basis of the injection across the battery terminals of sinusoidal current perturbations making it possible to determine the evolution of the LF impedance as a function of ageing, this step being performed during tests of the battery lifetime (cycling of the battery),
   - a step of identifying a preliminary model of the test battery (step 430),
   - a second series of measurements (B, step 431) of the current and the voltage across the battery terminals, making it possible to reproduce the raw telemetry data under real conditions of use of the battery,
   - a step 432 of calibrating a preliminary structure model which converts the raw telemetry data of the battery into LF impedance.

7. Method according to any one of claims 1 to 6, **characterized in that** the low-frequency impedance measurements are performed during a discharge phase of the battery.

8. Method according to any one of claims 1 to 7, **characterized in that** the voltage and the current of the battery are sampled at a frequency in the vicinity of 10 Hz.

9. Method according to any one of claims 1 to 8, **characterized in that**, in step 100, the measurements are acquired at any time during the normal use of the battery, these measurements covering at least one discharge period of the battery.

10. Device for diagnosing the ageing of a battery, **characterized in that** it implements a method according to any one of claims 1 to 9.

11. Satellite, **characterized in that** it comprises a device according to claim 10.

12. Computer program product comprising instructions which, when the program is executed by a computer, cause the computer to carry out a method according to any one of claims 1 to 9.

Figure 1

Figure 2

Figure 3

Figure 4

TEST DE REFERENCE DE VIEILLISSEMENT AU SOL

400

Test de référence de
durée de vie

Batterie de référence

410a

Mesure de capacité et
résistance interne

410

410b

Mesure d'impédance basse fréquence

431

Mesure d'impédance "B"

Mesure d'impédance "A"

430

Identification et validation
du modèle

432

Structure de modèle
préliminaire
(ex:ARX 7 7 0)

Tracé

420

Figure 5

Collection de
données (B)

431

432

Identification de modèle
(choix de structure de modèle)

Validation de données
d'entrée (courant
dynamique dans mesure "A")

Modèle
(ex:ARX 7 7 0)

Réponse dynamique
en voltage du modèle

Estimation de qualité
du modèle
(validation du modèle)

Validation de données
de sortie ( voltage
dynamique dans mesure "A")

Figure 6

Figure 7

Figure 8

Figure 9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20120019253 A1
- EP 1892536 A1
- US 4678998 A
- EP 2375487 A

**Littérature non-brevet citée dans la description**

- Impedance Noise Identification for State-of-Health Prognostics. *INL/CON-08-14101, 43rd Power Sources Conference,* Juillet 2008